# EUROPEAN PATENT SPECIFICATION

(11) **EP 2 793 033 B1**
(45) Date of publication and mention of the grant of the patent: **17.08.2016**
(21) Application number: 14425041.2
(22) Date of filing: 09.04.2014
(51) Int. Cl.: G01R 11/24

(54) **Improved detecting or measuring apparatus**
Verbesserte Detektions- oder Messvorrichtung
Appareil de mesure ou de détection améliorée

(30) Priority: 17.04.2013 IT RM20130229
(43) Date of publication of application: 22.10.2014
(73) Proprietor: BITRON S.p.A., 10122 Torino (IT)
(72) Inventor: Saccocci, Andrea, 10122 Torino (IT); Promutico, Fabrizio, 10122 Torino (IT)
(74) Representative: Tiburzi, Andrea

(56) References cited:
- WO-A1-2010/129829
- WO-A2-03/065055
- WO-A2-2008/078108
- CN-Y- 201 238 011
- GB-A- 190 917 488
- US-A- 4 542 337
- US-A- 4 583 483
- US-A1- 2011 048 907

## Description

The present invention relates to an improved detecting or measuring apparatus.

More specifically, the invention concerns an apparatus, in particular a electric energy meter, studied and realized in particular to detect and report any tampering attempts operated on it, but that can be adopted for any sensing device, in which the detections can be influenced by the surrounding magnetic field.

In the following, the description will be directed to anti-tampering device of an electric energy meter, but it is clear that the same should not be considered limited to this specific use.

Electric energy meters made by an outer casing provided with a front cover are known. These electric energy meters include internally a lever with an end articulated by a spring at the base of the meter and with its other end that presses on the inner wall of the front cover.

In case of attempt to remove the front cover, the lever is raised under the action of the spring force, activating an alarm circuit.

To prevent tampering attempts by external magnetic fields induced by electromagnets, these known meters are equipped with metal shields to protect an internal relay.

Such metallic screens are, however, ineffective in case of the tampering is carried out by a disturbance action carried getting close high powers electromagnets to the meter.

There are, also, measuring devices equipped, internally, with electronic devices sensitive to magnetic fields, which activate an alarm signal in case of high intensity magnetic fields.

However, considering the high production cost of the latter type of known devices, it is mainly directed to industrial utilities.

Another type of known solutions provides the use of casings external to the measurement apparatus, particularly cumbersome.

This allows, obviously, to increase the distance between the measurement apparatus and the magnet, used to tamper it, so as to reduce the intensity of the magnetic field interfering with the apparatus.

The international patent application WO 03/065055 describes an example of a measurement apparatus adapted to prevent fraudulent use by the application of a magnetic field interfering with it.

In light of the above, it is, therefore, object of the present invention to provide a device against tampering of a sensing device, in particular an electric energy device, capable to overcome the problems discussed with reference to the known solutions described above.

A further object of the invention is to provide a anti-tampering device for a detection apparatus, in particular of an electric energy meter, capable to improve the protection efficiency, without resorting to high-cost technologies and using the alarm signal of mechanical tampering normally already present in detection equipment.

Another object of the invention is to provide a device of the type indicated above, which is reliable in use, versatile and simple to manufacture.

It is therefore specific object of the present invention a detecting or measuring apparatus comprising an activation member, as a switch and the like, which can be activated by contact, for the activation of a warning system, and an anti-tamper device, comprising: a support, provided with longitudinal guide means and transversal guide means, arranged according to substantially mutually orthogonal directions, a sliding transverse member, slidably engaged with said transversal guide means and movable between a first central neutral position and two first lateral operating positions, respectively opposite said central neutral position, said sliding transverse member being provided with at least two elements, which react to a magnetic field, which they can be subjected to, so as to be subjected to attraction or repulsion and arranged in correspondence of opposite ends of said sliding transverse member, a longitudinal sliding member, slidably movable on said longitudinal guide means and provided with a projection, said longitudinal member being movable between a second neutral position and a second operating position, in which said projection contacts said activation member, movable connection means for the mutual movable connection of said sliding transverse member and said longitudinal sliding member, said movable connection means being configured in such a way that, when the sliding transverse member is arranged in said first central neutral position, the longitudinal sliding member is arranged in said second neutral position, and, when the sliding transverse member is arranged in one of said two first lateral operating positions, the longitudinal sliding member is arranged in said second operating position.

Still according to the invention, said movable connection means could comprise a substantially "V"-shaped opening and a pin movable in said "V"-shaped opening.

Preferably according to the invention, said pin could project from said sliding transverse member and in that said "V"-shaped opening is obtained on said longitudinal sliding member.

Further according to the invention, said anti-tamper device could comprise opposition means, adapted to create an opposing force to the movement of the sliding transverse member from said first central neutral position to said two first lateral operating positions.

Always according to the invention, said opposition means could comprise a spring, arranged between shoulders formed in the support and in the sliding transverse member.

Advantageously according to the invention, said apparatus could comprise a base and a cover mounted on said base, in which the support has a first end articulated to said base by means of elastic members, such as a spring and the like, and a supporting portion, arranged in correspondence of a second end, opposite said first end, pressing against an inner face of said cover by means of the action of said elastic members, said projection of the longitudinal sliding member being arranged in correspondence of said supporting portion of said support.

Still according to the invention, said longitudinal sliding member could have a substantially "Z"-shaped profile.

Preferably according to the invention, said at least two elements could be metallic or comprise ferrite.

The present invention will be now described, for illustrative but not limitative purposes, according to its preferred embodiments, with particular reference to the figures of the enclosed drawings, wherein:

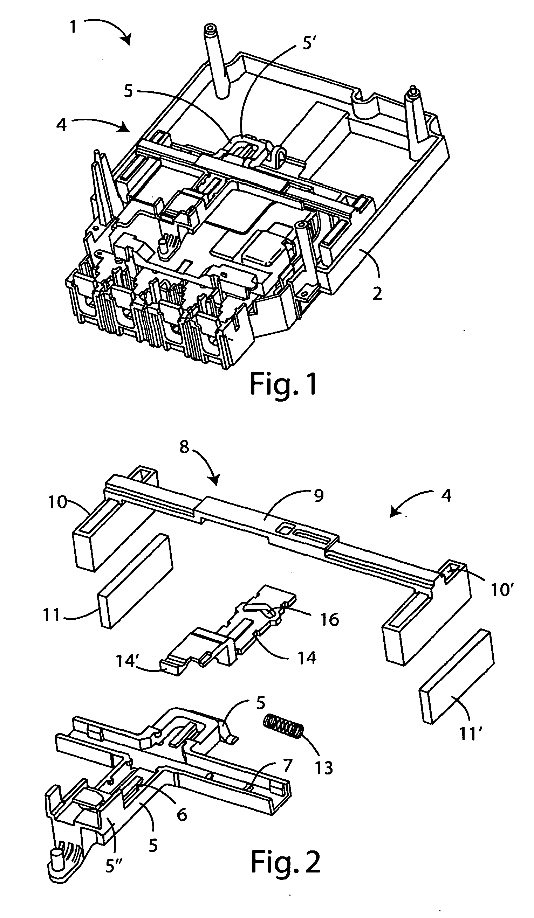

figure 1 is a partial view of an electric energy meter incorporating an anti-tamper device according to the present invention;
figure 2 is an exploded view of the anti-tamper device of figure 1;
figure 3 is a top plan view of the anti-tamper device according to figures 1 and 2, in a relative rest configuration;
figure 4 is a sectional detail view of figure 3;
figure 5 is a sectional partial view of the electric energy meter of figure 1 with the cover in a first operating mode;
figure 6 is a top plan view of the anti-tamper device according to figures 1 and 2, in a relative operating configuration;
figure 7 is a sectional detail view of figure 6; and
figure 8 is a sectional partial view of the electric energy meter of figure 1 with the cover in a second operating mode.

In the various figures, similar parts will be indicated by the same reference numbers.

Referring to the accompanying drawings, reference number 1 indicates an electric energy meter with an outer casing, in its turn formed by a base 2 and a cover 3 mounted on it.

Within said casing an anti-tamper device 4 is placed comprising a lever 5, having a connecting first end 5', articulated at the base 2 by means of a spring. Said lever 5 also includes a supporting portion 5" arranged in correspondence of a second end, opposite to said first end 5', which pushes on an inner face 3' of said cover 3.

The lever 5, in plan view, is substantially cross-shaped and has two grooves, one longitudinal 6 and the other transversal 7, mutually orthogonal.

The anti-tamper device 4 also includes a sliding transverse member 8, formed by a central crossbar 9, arranged so as to slide along said transversal groove 7 of the lever 5, and bearing, at its ends, two slots 10, 10' for respective inserts 11, 11'.

Said inserts 11, 11' can be metallic, or can comprise ferrite or any other material that reacts to a magnetic field to which it is subjected to, so as to undergo an attraction or a repulsion along the field force lines.

A pin 12 protrudes, inferiorly, from the central crossbar 9.

Between the lever 5 and the central crossbar 9 of the sliding transverse member 8 a spring 13 is placed, with the respective ends in abutment with the shoulders obtained both on said lever 5, and on said central crossbar 9.

The anti-tamper device 4 also comprises a longitudinal sliding member 14, having a substantially "Z"-shaped profile, capable of sliding along the longitudinal groove 6 of said lever 5.

The longitudinal sliding member 14 is also provided, at one of its ends, with a tooth 14' arranged at the end of the supporting portion 5" of the lever 5 and with an activation member 15 of an alarm system, such as a microswitch and the like.

An opening 16 is obtained on the longitudinal sliding member 14 being substantially inverted "V"-shaped in plan view.

The pin 12 that projects from the central crossbar 9 is slidably engaged with said opening 16 of the longitudinal sliding member 14, and constrained to move within it.

The operation of the electric energy meter described above is as follows.

When the cover 3 is removed from the base 2 for tampering the electric energy meter 1, lever 5, which presses on the internal face 3' of said cover 3, is lifted due to the pushing action of said spring that engages with the base 2, carrying with it, in its lifting movement, also the longitudinal sliding member 14. This latter, rising, come into contact with the activation member 15, thus causing the activation of the alarm system.

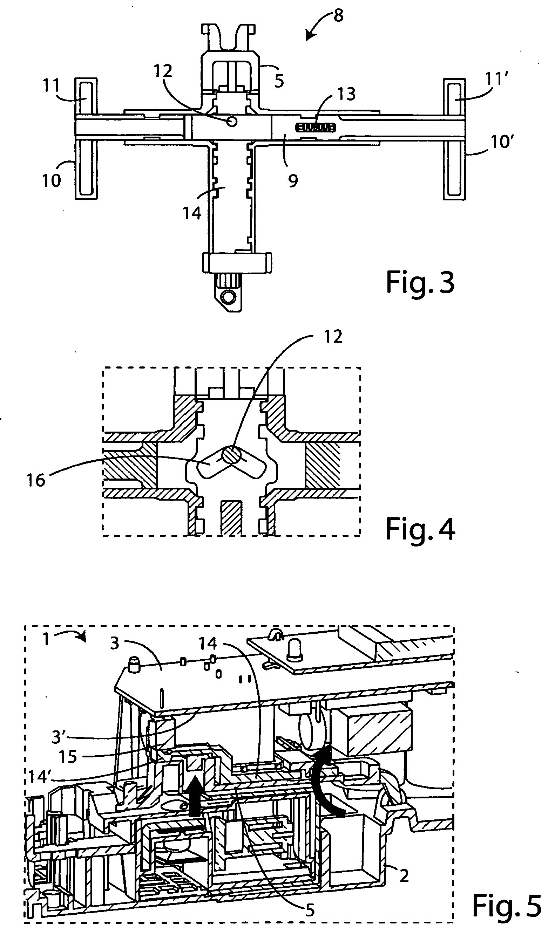

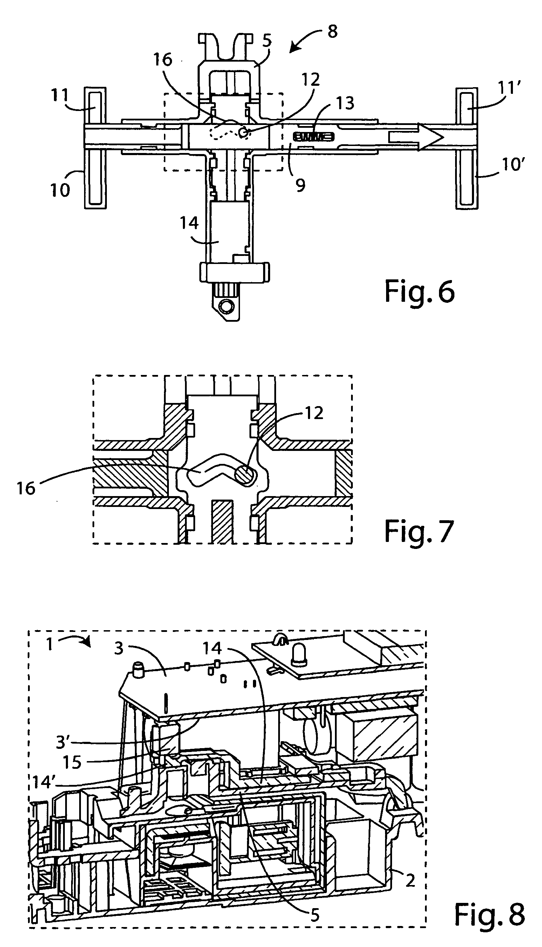

If, however, a magnet is placed in close proximity to the electric energy meter 1 to put in place a tampering attempt, this magnet will attract towards itself, overcoming the spring 13 opposing force, one of the two inserts 11 or 11', thus causing a translation displacement of the sliding transverse member 8 on the transversal groove 7 of the lever 5, from a rest position (see figure 3), in which pin 12 is in correspondence of the upper vertex of the opening 16, to an operating position (see figure 6), in which pin 12 is arranged in one of the two lower ends of opening 16.

The occupation of one of the above upper ends of the opening 16 by pin 12 causes the translation of the longitudinal sliding member 14 along the longitudinal groove 6 of lever 5 and the contact of tooth 14' with said activation member 15, with the following activation of said alarm system.

The particular structure of the anti-tamper device 4 allows the operation according to the procedures described above in cases of the magnet is close to any of the two opposite sides of the electric energy meter 1, with the two inserts 11, 11'.

According to a further embodiment of the present invention, not shown in the enclosed figures, the casing of the electric energy meter described above can be formed by a single piece. In this case, the lever described above is replaced by a support similarly shaped, fixed with respect to such an electric energy meter.

The present invention has been described for illustrative but not limitative purposes, according to its preferred embodiments, but it is to be understood that modifications and/or changes can be introduced by those skilled in the art without departing from the relevant scope as defined in the enclosed claims.

## Claims

1. Detecting or measuring apparatus (1) comprising
an activation member (15), as a switch and the like, which can be activated by contact, for the activation of a warning system, and
an anti-tamper device (4), comprising:
a support (5), provided with longitudinal guide means (6) and transversal guide means (7), arranged according to substantially mutually orthogonal directions,
a sliding transverse member (8), slidably engaged with said transversal guide means (7) and movable between a first central neutral position and two first lateral operating positions, respectively opposite said central neutral position, said sliding transverse member (8) being provided with at least two elements (11, 11'), which react to a magnetic field, which they can be subjected to, so as to be subjected to attraction or repulsion and arranged in correspondence of opposite ends of said sliding transverse member (8),
a longitudinal sliding member (14), slidably movable on said longitudinal guide means (6) and provided with a projection (14'), said longitudinal member (14) being movable between a second neutral position and a second operating position, in which said projection (14') contacts said activation member (15),
movable connection means (12, 16) for the mutual movable connection of said sliding transverse member (8) and said longitudinal sliding member (14), said movable connection means (12, 16) being configured in such a way that, when the sliding transverse member (8) is arranged in said first central neutral position, the longitudinal sliding member (14) is arranged in said second neutral position, and, when the sliding transverse member (8) is arranged in one of said two first lateral operating positions, the longitudinal sliding member (14) is arranged in said second operating position.

2. Apparatus according to claim 1, **characterized in that** said movable connection means comprises a substantially "V"-shaped opening (16) and a pin (12) movable in said "V"-shaped opening (16).

3. Apparatus according to claim 2, **characterized in that** said pin (12) projects from said sliding transverse member (8) and **in that** said "V"-shaped opening (16) is obtained on said longitudinal sliding member (14).

4. Apparatus according to anyone of the preceding claims, **characterized in that** said anti-tamper device (4) comprises opposition means (13), adapted to create an opposing force to the movement of the sliding transverse member (8) from said first central neutral position to said two first lateral operating positions.

5. Apparatus according to claim 4, **characterized in that** said opposition means comprise a spring (13), arranged between shoulders formed in the support (5) and in the sliding transverse member (8).

6. Apparatus according to anyone of the preceding claims, **characterized in that** it comprises a base (2) and a cover (3) mounted on said base (2), in which the support (5) has a first end (5') articulated to said base (2) by means of elastic members, such as a spring and the like, and a supporting portion (5"), arranged in correspondence of a second end, opposite said first end (5'), pressing against an inner face (3') of said cover (3) by means of the action of said elastic members, said projection (14') of the longitudinal sliding member (14) being arranged in correspondence of said supporting portion (5") of said support (5).

7. Apparatus according to anyone of the preceding claims, **characterized in that** said longitudinal sliding member (14) has a substantially "Z"-shaped profile.

8. Apparatus according to anyone of the preceding claims, **characterized in that** said at least two elements (11, 11') are metallic or comprise ferrite.

## Patentansprüche

1. Erfassungs- oder Messvorrichtung (1), umfassend ein Betätigungselement (15); wie ein Schalter und ähnliches, die durch den Kontakt aktiviert werden kann, zur Aktivierung eines Warnsystems, und
ein längliches Gleitelement als Manipulationsschutz (4), umfassend:
eine Halterung, (5) mit Vorrichtungen zur Führung in Längsrichtung (6) sowie in Querrichtung (7) angeordnet in im Wesentlichen zueinander orthogonalen Richtungen,
ein quer verlaufendes Gleitelement (8), das verschiebbar in die genannten Führungsvorrichtungen in Querrichtung (7) greift und zwischen einer ersten zentralen Neutralstellung und zwei ersten seitlichen Betriebsstellungen beweglich ist, die jeweils gegenüber der zentralen Neutralstellung liegen, dieses quer verlaufende Gleitelement (8) ist mit zumindest zwei Elementen (11, 11') ausgerüstet, die auf ein Magnetfeld reagieren, dem sie ausgesetzt werden können, damit eine Anziehung oder eine Abstoßung ausgeübt werden kann und sie sind an den jeweils entgegengesetzten Endstücken des genannten, quer verlaufenden Gleitelements (8) angeordnet;
ein längliches Gleitelement, (14) gleitend beweglich an der Längsführungsvorrichtung (6) und ausgestattet mit einer Ausbuchtung (14'), dieses längs verlaufende Element (14) ist beweglich zwischen einer zweiten Neutralstellung und einer zweiten Betriebsstellung, in der diese Ausbuchtung (14') in Kontakt mit dem genannten Aktivierungselement (15) kommt,
bewegliche Verbindungsvorrichtungen (12, 16) für die wechselseitig beweglichen Verbindung des genannten Quer-Gleitelementes (8) und des Längs-Gleitelementes (14), wobei die beweglichen Verbindungsvorrichtungen (12, 16) so konfiguriert sind, dass, wenn das Quer-Gleitelement (8) in der genannten ersten zentralen Neutralstellung angeordnet ist, das Längs-Gleitelement (14) in der zweiten Neutralstellung angeordnet ist, und, wenn das Quer-Gleitelement (8); in einer der beiden genannten ersten seitlichen Betriebsstellungen angeordnet ist, wird das Längs-Gleitelement (14) in der genannten zweiten Betriebsstellung angeordnet.

2. Gerät gemäß Anspruch 1, **dadurch gekennzeichnet, dass** die genannte beweglichen Verbindungsmittel eine im Wesentlichen "V"-förmige Öffnung (16) und einen Zapfen (12) umfassen, der in der genannten "V"-förmigen Öffnung (16) beweglich ist.

3. Gerät gemäß Anspruch 2, **dadurch gekennzeichnet, dass** dieser Zapfen (12) aus dem genannten Quer-Gleitelement (8) herausragt und dass die genannte "V"-förmige Öffnung (16) auf dem genannten Längs-Gleitelement (14) vorgesehen ist.

4. Gerät gemäß einem der vorhergehenden Ansprüche, **dadurch gekennzeichnet, dass** der genannte Manipulationsschutz (4) eine Gegenvorrichtung (13) umfasst, die in der Lage ist, eine der Bewegung des Quer-Gleitelementes (8), aus der genannten Zentralen Neutralstellung in die genannten beiden ersten seitlichen Betriebspositionen entgegenwirkende Kraft auszuüben.

5. Gerät gemäß Anspruch 4, **dadurch gekennzeichnet, dass** die genannte Gegenvorrichtung eine Feder (13) umfasst, angeordnet zwischen im Halter (5) und dem Quer-Gleitelement (8) vorgesehenen Schultern.

6. Gerät gemäß einem der vorhergehenden Ansprüche, **dadurch gekennzeichnet, dass** es eine Basis (2) und eine Abdeckung (3) umfasst, die auf dieser Basis (2) montiert ist, in der der Halter (5) ein erstes Endstück (5') aufweist, das zu dieser Basis (2) über biegsame Elemente, wie eine Feder und ähnliches, abgewinkelt ist sowie ein tragendes Teilstück (5") angeordnet entsprechend deinem zweiten Endstück, gegenüber dem genannten ersten Endstück (5'), das, durch die Wirkung der genannten biegsame Elemente gegen eine Innenseite (3') der genannten Abdeckung (3) drückt, die genannte Ausbuchtung (14') des Längs-Gleitelementes (14) ist entsprechend des genannten tragenden Teilstücks (5") des genannten Halters (5) angeordnet.

7. Gerät gemäß einem der vorhergehenden Ansprüche, **dadurch gekennzeichnet, dass** dieses Längs-Gleitelement (14) ein im Wesentlichen "Z"-förmiges Profil aufweist.

8. Gerät gemäß einem der vorhergehenden Ansprüche, **dadurch gekennzeichnet, dass** diese mindestens zwei Elemente (11, 11') aus Metall bestehen oder Ferrit enthalten.

## Revendications

1. Appareil de mesure ou de détection (1) comprenant
un élément d'activation (15), comme un commutateur et ainsi de suite, qui peut être activé par contact, pour l'activation d'un système d'avertissement, et
un dispositif inviolable (4), comprenant :
un support (5), muni d'un moyen de guidage longitudinal (6) et d'un moyen de guidage transversal (7), agencés selon des directions sensiblement mutuellement orthogonales,
un élément transversal coulissant (8), en prise de manière coulissante avec ledit moyen de guidage transversal (7) et mobile entre une première position neutre centrale et deux premières positions latérales de mise en oeuvre, respectivement en face de ladite position neutre centrale, ledit élément transversal coulissant (8) étant muni d'au moins deux éléments (11, 11'), qui réagissent à un champ magnétique, auquel ils peuvent être soumis, afin d'être soumis à une attraction ou une répulsion et agencés en correspondance aux extrémités opposées dudit élément transversal coulissant (8),
un élément coulissant longitudinal (14), mobile de manière coulissante sur ledit moyen de guidage longitudinal (6) et muni d'une partie en saillie (14'), ledit élément longitudinal (14) étant mobile entre une seconde position neutre et une seconde position de mise en oeuvre, dans lequel ladite partie en saillie (14') entre en contact avec ledit élément d'activation (15),
un moyen de connexion mobile (12, 16) pour la connexion mobile mutuelle dudit élément transversal coulissant (8) et dudit élément coulissant longitudinal (14), ledit moyen de connexion mobile (12, 16) étant configuré d'une telle façon que, lorsque l'élément transversal coulissant (8) est agencé dans ladite première position neutre centrale, l'élément coulissant longitudinal (14) est agencé dans ladite seconde position neutre et, lorsque l'élément transversal coulissant (8) est agencé dans une desdites deux premières positions latérales de mise en oeuvre, l'élément coulissant longitudinal (14) est agencé dans ladite seconde position de mise en oeuvre.

2. Appareil selon la revendication 1, **caractérisé en ce que** ledit moyen de connexion mobile comprend une ouverture sensiblement en forme de « V » (16) et un ergot (12) mobile dans ladite ouverture en forme de « V » (16).

3. Appareil selon la revendication 2, **caractérisé en ce que** ledit ergot (12) dépasse dudit élément transversal coulissant (8) et **en ce que** ladite ouverture en forme de « V » (16) est obtenue sur ledit élément coulissant longitudinal (14).

4. Appareil selon l'une quelconque des revendications précédentes, **caractérisé en ce que** ledit dispositif inviolable (4) comprend un moyen d'opposition (13), conçu pour créer une force d'opposition au mouvement de l'élément transversal coulissant (8) de ladite première position neutre centrale auxdites deux premières positions latérales de mise en oeuvre.

5. Appareil selon la revendication 4, **caractérisé en ce que** ledit moyen d'opposition comprend un ressort (13), agencé entre des épaulements formés dans le support (5) et dans l'élément transversal coulissant (8).

6. Appareil selon l'une quelconque des revendications précédentes, **caractérisé en ce qu'**il comprend une base (2) et un couvercle (3) monté sur ladite base (2), dans lequel le support (5) a une première extrémité (5') articulée à ladite base (2) au moyen d'éléments élastiques, comme un ressort et ainsi de suite, et une partie de support (5"), agencée en correspondance à une seconde extrémité, opposée à ladite première extrémité (5'), pressant contre une face intérieure (3') dudit couvercle (3) au moyen de l'action desdits éléments élastiques, ladite partie en saillie (14') de l'élément coulissant longitudinal (14) étant agencée en correspondance à ladite partie de support (5") dudit support (5).

7. Appareil selon l'une quelconque des revendications précédentes, **caractérisé en ce que** ledit élément coulissant longitudinal (14) a un profil sensiblement en forme de « Z ».

8. Appareil selon l'une quelconque des revendications précédentes, **caractérisé en ce que** lesdits au moins deux éléments (11, 11') sont métalliques ou comprennent de la ferrite.
